# EUROPÄISCHE PATENTSCHRIFT

(11) **EP 2 517 226 B1**
(45) Veröffentlichungstag und Bekanntmachung des Hinweises auf die Patenterteilung: **09.06.2021**
(21) Anmeldenummer: 10798338.9
(22) Anmeldetag: 23.12.2010
(51) Int. Cl.: H01L 21/67

(54) **VERFAHREN UND VORRICHTUNG ZUR BEHANDLUNG VON SILIZIUMSUBSTRATEN**
METHOD AND DEVICE FOR TREATING SILICON SUBSTRATES
PROCÉDÉ ET DISPOSITIF POUR LE TRAITEMENT DE SUBSTRATS DE SILICIUM

(30) Priorität: 23.12.2009 DE 102009060931
(43) Veröffentlichungstag der Anmeldung: 31.10.2012
(73) Patentinhaber: Gebr. Schmid GmbH, 72250 Freudenstadt (DE)
(72) Erfinder: HABERMANN, Dirk, 79199 Kirchzarten (DE); SCHOCH, Martin, 72250 Freudenstadt (DE); IZAARYENE, Maher, 52074 Aachen (DE); STEIN, Friedhelm, 72290 Loßburg (DE)
(74) Vertreter: Patentanwälte Ruff, Wilhelm, Beier, Dauster & Partner mbB
(86) Internationale Anmeldenummer: PCT/EP2010/070651
(87) Internationale Veröffentlichungsnummer: WO 2011/076920

(56) Entgegenhaltungen:
- EP-A2- 0 222 348
- DE-A1-102007 026 081
- DE-A1-102007 063 202
- JP-A- 2005 019 605
- US-A1- 2008 044 956

## Beschreibung

Die Erfindung betrifft ein Verfahren zur Behandlung von Siliziumsubstraten sowie eine dazu geeignete Vorrichtung. Insbesondere geht es dabei um die Behandlung von monokristallinen Silizium-Wafern, deren Oberseite und vorteilhaft auch Unterseite zum Texturieren mit Ätzlösung behandelt wird.

Aus der DE 102007063202 A1 ist es bekannt, Siliziumsubstrate von oben permanent mit Ätzlösung zu beschwallen. Als Ätzlösung wird dabei eine Mischung aus HF und HNO₃ verwendet. Durch das Ätzen erfolgt eine bekannte Texturierung des Siliziumsubstrats.

Auch aus der DE 102008022282 A1 ist es bekannt, Siliziumsubstrate durch Ätzen zu texturieren. Dabei werden entstehende Gasblasen auf der Oberfläche der Siliziumsubstrate durch breite, oben anliegende Walzen abgequetscht und entfernt, so dass ein möglichst gleichbleibendes Ätzergebnis erreicht wird.

Aus der DE 102007026081 A1 ist ein Verfahren zur texturierenden Behandlung von Siliziumwafern bekannt, bei dem als Behandlungsfluid Kaliumhydroxid verwendet wird, dem ein Additiv in einer Menge zwischen 1% und 15%, vorzugsweise zwischen 5% und 10%, beigemischt wird. Bei dem Additiv kann es sich z.B. um Sorbitol handeln, welches in Form eines Pulvers aus einem Tank in die Behandlungsflüssigkeit beigemischt wird, und zwar entweder in einem separaten Behälter oder direkt in ein betreffendes Bad.

### Aufgabe und Lösung

Der Erfindung liegt die Aufgabe zugrunde, ein eingangs genanntes Verfahren sowie eine entsprechende Vorrichtung zur Behandlung von Siliziumsubstraten zu schaffen, mit denen Probleme des Standes der Technik vermieden werden können und insbesondere auch monokristalline Silizium-Wafer behandelt bzw. an ihrer Oberseite texturiert werden können mit möglichst geringem Aufwand.

Gelöst wird diese Aufgabe durch ein Verfahren mit den Merkmalen des Anspruchs 1 sowie eine Vorrichtung mit den Merkmalen des Anspruchs 8. Vorteilhafte sowie bevorzugte Ausgestaltungen der Erfindung sind Gegenstand der weiteren Ansprüche und werden im Folgenden näher erläutert. Manche der nachfolgend genannten Merkmale werden nur für das Verfahren oder nur für die Vorrichtung beschrieben. Sie sollen jedoch unabhängig davon sowohl für das Verfahren als auch für die Vorrichtung gelten können. Der Wortlaut der Ansprüche wird durch ausdrückliche Bezugnahme zum Inhalt der Beschreibung gemacht.

Es ist vorgesehen, dass die Siliziumsubstrate liegend entlang einer horizontalen Transportbahn transportiert werden, also in einem Inline-Verfahren behandelt werden. Dies bietet Vorteile gegenüber bisherigen Verfahren, bei denen die Siliziumsubstrate vertikal gehalten wurden. Zumindest von oben bzw. auf die Oberseite der Siliziumsubstrate wird Ätzlösung zum Texturieren der Oberfläche aufgebracht bzw. aufgesprüht, was mittels Düsen bzw. Schwalldüsen oder ähnlichen Ausbringvorrichtungen erfolgen kann. Dabei wird Ätzlösung mehrfach hintereinander, also sowohl zeitlich hintereinander als auch in Durchlaufrichtung gesehen, von oben auf die Oberseite der Siliziumsubstrate gebracht. Sie verbleibt auf der Oberseite und reagiert mit dem Siliziumsubstrat bzw. ätzt es zum Texturieren. Dabei können wenige Mikrometer des Siliziumsubstrats abgetragen werden. So entstehen die bekannten Pyramidenformen auf der Oberfläche, welche eine bessere Einkopplung bzw. geringere Reflexion von Sonnenlicht bei einer aus dem Siliziumsubstrat gefertigten Solarzelle bewirken. Durch das mehrfache Aufbringen der Ätzlösung wird diese jeweils ausgetauscht bzw. erneuert, so dass der Ätzvorgang mit stets frischer bzw. aufgefrischter Ätzlösung erfolgt. Des Weiteren wird dadurch ein möglichst gleichmäßiges Ätzergebnis erreicht.

Zur noch weiteren Verbesserung des Ätzvorgangs ist erfindungsgemäß ein Additiv in der Ätzlösung enthalten, welches aus der Gruppe bestehend aus Alkohol, Tensid oder Glykol ausgewählt ist und eines oder mehrere davon umfassen kann. Dieses Additiv ist mit einem geringen Anteil von weniger als 1 Gew.%, vorteilhaft zwischen 0,3 Gew.% und 0,6 Gew.%, in der Ätzlösung enthalten. Ein solches Additiv bewirkt ganz hauptsächlich, dass durch Reduzieren der Oberflächenspannung der Ätzlösung ein Anhaften der Gasblasen aus der Reaktion verringert oder sogar ganz vermieden wird, welche dadurch entsteht, dass die Silizium-Oberfläche mit der Ätzlösung behandelt wird. Die durch die Ätzreaktion entstehenden Gase und die dadurch gebildeten Blasen stören den Ätzvorgang, da sie an der Oberseite verbleiben und den von ihnen bedeckten Bereich der Oberfläche abschirmen, so dass hier eine geringere oder sogar gar keine Ätzung mehr stattfindet. Der erfindungsgemäß relativ geringe Anteil an Additiv hat sich in der Praxis als ausreichend erwiesen und ermöglicht es, die Blasenbildung deutlich zu reduzieren für ein verbessertes Ätzergebnis.

Mehrere derartige Benetzungsvorrichtungen, beispielsweise als Düsen bzw. Schwalldüsen oder ähnliche Ausbringvorrichtungen ausgebildet, sind hintereinander in Durchlaufrichtung der Substrate durch die Vorrichtung vorgesehen. Sie ermöglichen es, die Substrate in Zeitintervallen von 1-300 sek auf der Oberfläche abermals mit frischer Chemie zu beschichten.

Sonstige Möglichkeiten sind ein Bearbeiten der zu ätzenden Oberseite mit Quetschwalzen gemäß der DE 102008022282 A1, die durch linienartigen Kontakt auf der Oberseite der Siliziumsubstrate entstehende Blasen sozusagen abquetschen oder wegquetschen und wieder neue Ätzlösung an die Oberseite bringen, oder ein permanentes starkes Beschwallen oder Beströmen mit Ätzlösung, um dadurch die Blasen zu entfernen. Im Vergleich dazu weist das erfindungsgemäße Verfahren den Vorteil auf, dass es weit weniger konstruktiven bzw. mechanischen Aufwand und weniger ungewünschte Beeinträchtigung der Siliziumsubstrat-Oberfläche mit sich bringt. Durch den geringen Anteil des Additivs in der Ätzlösung wird die Ätzwirkung nur minimal oder gar nicht negativ beeinflusst. Gleichzeitig reicht dieser geringe Anteil schon, um die Oberflächenspannung in der Ätzlösung so weit zu reduzieren, dass sich eben die genannten unerwünschten Blasen beim Ätzvorgang nicht an der Oberfläche haften bleiben.

Erfindungsgemäß wird das Additiv in die Ätzlösung nachdosiert. Insbesondere kann dies im zeitlichen Verlauf geschehen, kurz bevor die Ätzlösung auf das Siliziumsubstrat aufgebracht wird. Üblicherweise wird die Ätzlösung in einer Art großem Vorratstank oder Behälter gesammelt, beispielsweise auch einer Sammelwanne, woraus sie entnommen wird zum Aufbringen auf das Siliziumsubstrat. Wenn hier bereits das Additiv eingebracht wird, insbesondere ein sehr flüchtiges bzw. leicht verdampfendes Additiv wie Alkohol, so kann es sich verflüchtigen. Zum einen ist es dann nicht mehr in der Ätzlösung vorhanden. Zum anderen stellt es ein Umweltproblem dar und kann sowohl die Vorrichtung bzw. Anlage angreifen als auch eine Belastung für Bedienpersonen sein. Besonders vorteilhaft wird das Additiv erst dort der Ätzlösung zugesetzt, wo die Ätzlösung kurz davor steht, auf das Siliziumsubstrat aufgebracht zu werden. Insofern kann das Additiv erst in eine Benetzungsvorrichtung eindosiert werden, beispielsweise in ein längliches Rohr oder einen gleichartigen Behälter, der sich quer über die Transportbahn der Siliziumsubstrate erstreckt und mit Düsen odgl. versehen ist, durch die die Ätzlösung ausgebracht wird. So kann die Ätzlösung beispielsweise über eine Zusatzöffnung zur Nachdosierung an einen Anschluss der Benetzungsvorrichtung an eine Zuleitung für die Ätzlösung angeschlossen sein.

In nochmals vorteilhafter Weiterbildung der Erfindung wird das Additiv permanent in die Ätzlösung nachdosiert. Dies betrifft also die mittels der Benetzungsvorrichtung ausgebrachte Ätzlösung, so dass das Additiv jeweils entsprechend der Menge der ausgebrachten Ätzlösung nachdosiert wird.

In einer Ausgestaltung der Erfindung kann vorgesehen sein, dass der Ätzlösung im zeitlichen Fortgang des Ätzens bzw. in Durchlaufrichtung der Siliziumsubstrate immer mehr Additiv zugesetzt wird für einen immer höheren Anteil an Additiv in der Ätzlösung. So kann sich der Anteil von Additiv in der Ätzlösung von Beginn des Ätzens bis zum Ende stark erhöhen, beispielsweise sogar verdoppeln.

In vorteilhafter Ausgestaltung der Erfindung wird eine alkalische Ätzlösung verwendet. Sie kann in geringer Menge aufweisen NaOH und/oder KOH, vorteilhaft beides zusammen. Dieser Anteil beträgt beispielsweise zwischen 1 Gew.% und 10 Gew.%, vorteilhaft etwas über 3 Gew.%. Hier hat sich herausgestellt, dass so ein besonders erfolgreiches Ätzen der Oberseite der Siliziumsubstrate erfolgt.

In nochmals weiterer Ausgestaltung der Erfindung ist es möglich, erwärmte Ätzlösung für die Siliziumsubstrate zu verwenden. Dazu kann vorteilhaft die Ätzlösung vor dem Aufbringen auf die Siliziumsubstrate beheizt werden bzw. erwärmt werden. Dies kann entweder in einem vorbeschriebenen Vorrat von Ätzlösung erfolgen, beispielsweise auch in einer Auffangwanne in der genannten Anlage. Alternativ oder zusätzlich kann eine Heizung direkt in einer Benetzungsvorrichtung für die Ätzlösung angeordnet sein, beispielsweise als übliche, elektrisch betriebene Heizschlange bzw. Rohrheizkörper, IR-Strahler, Mikrowellenheizung, Induktionsheizung odgl.. Ein Erwärmen der Ätzlösung kann auf einige °C über Raumtemperatur erfolgen, beispielsweise 30°C bis 80°C, vorteilhaft 40°C bis 70°C.

In nochmals weiterer Ausgestaltung der Erfindung kann nicht nur die nach oben weisende Oberseite der Siliziumsubstrate mit der Ätzlösung behandelt bzw. texturiert werden, sondern auch die nach unten weisende Unterseite. Dies kann durch Besprühen von unten erfolgen oder durch eine oder mehrere Benetzungsrollen, über die die Siliziumsubstrate laufen bzw. transportiert werden. Diese Benetzungsrollen sind mindestens so breit wie ein Siliziumsubstrat oder noch breiter und ihre Oberfläche ist mit Ätzlösung benetzt, um die Ätzlösung auf die Unterseite der Siliziumsubstrate zu übertragen. Dies ist aber grundsätzlich aus dem Stand der Technik bekannt, siehe beispielsweise die DE 102005062528 A1. Auch kann das Niveau der Ätzlösung im Becken so hoch eingestellt werden, bis es die zu behandelnde Oberfläche der Substrate berührt. Diese und weitere Merkmale gehen außer aus den Ansprüchen auch aus der Beschreibung und den Zeichnungen hervor. Der Gegenstand der Erfindung ist in den Ansprüchen definiert. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im Folgenden näher erläutert. In den Zeichnungen zeigen.
- Fig. 1: eine Ansicht einer erfindungsgemäßen Anlage in Durchlaufrichtung der Substrate gesehen und
- Fig. 2: eine Seitenansicht eines Teils der Anlage aus Fig. 1

### Detaillierte Beschreibung der Ausführungsbeispiele

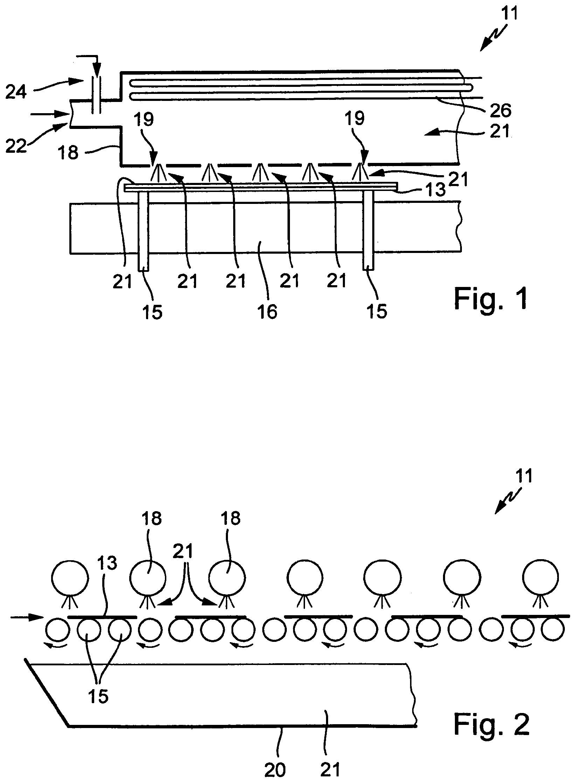

In Fig. 1 ist eine erfindungsgemäße Anlage 11 als Vorrichtung zur Behandlung von Silizium-Wafern 13 als Siliziumsubstrate dargestellt, und zwar in Durchlaufrichtung dieser Silizium-Wafer 13. Dabei liegen sie entlang einer horizontalen Transportbahn, die von Transportrollen 15 auf Transportwellen 16 gebildet ist. Mehrere Silizium-Wafer 13 können dabei nebeneinander durch die Anlage 11 gefahren werden und, wie Fig. 2 zeigt, viele hintereinander mit geringem Abstand.

Oberhalb der Transportbahn ist ein Schwallrohr 18 als Benetzungsvorrichtung vorgesehen, welches einen Abstand von wenigen Zentimetern zu der Oberseite der Silizium-Wafer 13 aufweist und über die gesamte Breite der Transportbahn reicht. Mehrere Schwallrohre 18 hintereinander überdecken die Transportbahn in der Länge. Der Abstand der Schwallrohre 18 in Fig. 2 kann beispielsweise etwa 15 cm betragen, möglicherweise aber auch etwas mehr oder etwas weniger oder sich auch im Verlauf der Transportbahn ändern.

Das Schwallrohr 18 weist an seiner Unterseite mehrere Schwalldüsen 19 auf, die als einfache Löcher, Öffnungen oder Schlitze ausgebildet sein können. Durch sie kann Ätzlösung 21 austreten und auf die Oberseite des Silizium-Wafers 13 kommen und sich dort verteilen, wie dargestellt ist.

Des Weiteren ist an dem Schwallrohr 18 eine Nachdosierung 24 als separater Anschluss vorgesehen. Hier kann ein eingangs genanntes Additiv oder mehrere davon nachdosiert bzw. der Ätzlösung 21 zudosiert werden. Dies kann derart kurz vor dem Ausbringen der Ätzlösung 21 aus dem Schwallrohr 18 erfolgen, dass eine Verdunstung der vorgenannten leicht flüchtigen Additive sehr gering gehalten wird oder ganz vermieden werden kann. Aus der Fig. 1 und aus der Fig. 2 mit der unterhalb der Transportrollen 15 angeordneten Sammelwanne 20 ist nämlich gut zu ersehen, dass nach dem Aufbringen der Ätzlösung 21 auf die Oberseite der Silizium-Wafer 13, wo sie eine durchgehende Schicht bildet, natürlich auch Ätzlösung 21 davon herunter läuft oder herunter tropft. Allerdings wird das leicht flüchtige Additiv aus der Nachdosierung 24, welches bereits auch vorher in der Ätzlösung 21 vorhanden sein kann bzw. eingebracht worden sein kann, bereits vor dem Abtropfen von dem Silizium-Wafer 13 zu einem guten Teil verflüchtigt sein und nur eine geringe Menge davon in die Sammelwanne 20 oder auf die Transportrollen 15 gelangen. Somit kann das Additiv zwar noch seine Funktion zum Abbau von Oberflächenspannung in der Ätzlösung 21 auf dem Silizium-Wafer 13 ausüben, die gesamte Anlage 11 aber nicht so sehr in Mitleidenschaft ziehen. Flüchtige Additive können über Saugrohre, die zwischen den Rollen angeordnet sind, abgesaugt werden.

In der Ätzlösung 21 können neben Isopropanol auch andere Additive, vorteilhaft ein Tensid, in geringer Menge vorhanden sein. Dies reduziert die Blasenbildung beim Ätzen der Oberfläche des Wafers noch einmal deutlich. Durch die Nachdosierung 24 für das Additiv ist es nun insbesondere möglich, genau die Menge an Additiv bzw. beispielsweise an Alkohol bzw. Isopropanol zuzuführen, die unmittelbar für die chemische Reaktion auf der Oberfläche des Silizium-Wafers 13 notwendig ist. Auch die Rückseite des Siliziumsubstrats kann mit der Ätzlösung 21 benetzt und geätzt werden. Dazu können die Transportrollen, wie beispielsweise in der DE 102007063202 A1 oder in der DE 102005062528 A1 beschrieben, entweder zusätzlich an der Unterseite mit Ätzlösung 21 besprüht werden oder aber durch sich über die gesamte Breite der Wafer erstreckenden Transportrollen 15 eben auch an der Unterseite benetzt und geätzt werden.

## Patentansprüche

1. Verfahren zur Behandlung von Siliziumsubstraten, insbesondere monokristallinen Silizium-Wafern (13), wobei die Siliziumsubstrate liegend entlang einer horizontalen Transportbahn transportiert werden und zumindest von oben Ätzlösung (21) zum Texturieren der Oberfläche aufgebracht oder aufgesprüht wird mittels Düsen (19) oder dgl., wobei Ätzlösung mehrfach hintereinander von oben auf die Oberseite der Siliziumsubstrate gebracht wird und darauf verbleibt und mit dem Siliziumsubstrat reagiert, **dadurch gekennzeichnet, dass** in der Ätzlösung ein Additiv aus der Gruppe bestehend aus Alkohol, Tensid, Glykol enthalten ist mit einem Anteil von kleiner 1 Gew.%, und wobei der Ätzlösung im zeitlichen Fortgang des Ätzens oder in einer Durchlaufrichtung immer mehr Additiv zugesetzt wird für einen sich erhöhenden Anteil an Additiv.

2. Verfahren nach Anspruch 1, **dadurch gekennzeichnet, dass** der Anteil an Additiv zwischen 0,3 Gew.% und 0,6 Gew.% beträgt.

3. Verfahren nach Anspruch 1 oder 2, **dadurch gekennzeichnet, dass** das Additiv in die Ätzlösung zusätzlich nachdosiert wird und/oder das Additiv permanent in die Ätzlösung nachdosiert wird.

4. Verfahren eime der vorhergehenden Ansprüche, **dadurch gekennzeichnet, dass** der Anteil an Additiv zum Ende hin erhöht wird, vorzugsweise bis zu verdoppelt.

5. Verfahren nach einem der vorhergehenden Ansprüche, **dadurch gekennzeichnet, dass** die Ätzlösung alkalisch ist, wobei sie vorzugsweise eine Menge KOH und/oder NaOH zwischen 1 Gew.% und 10 Gew.% aufweist..

6. Verfahren nach einem der vorhergehenden Ansprüche, **dadurch gekennzeichnet, dass** die Ätzlösung vor dem Aufbringen auf die Siliziumsubstrate beheizt wird, vorzugsweise in einem Vorrat von Ätzlösung oder in einer Benetzungsvorrichtung für die Ätzlösung.

7. Verfahren nach einem der vorhergehenden Ansprüche, **dadurch gekennzeichnet, dass** auch die nach unten weisende Unterseite der Siliziumsubstrate mit der Ätzlösung benetzt wird, vorzugsweise durch Besprühen von unten oder durch eine oder mehrere Benetzungsrollen, über die die Siliziumsubstrate laufen bzw. transportiert werden und deren Oberfläche mit Ätzlösung benetzt ist zur Übertragung der Ätzlösung auf die Unterseite der Siliziumsubstrate.

8. Vorrichtung zu Behandlung von Siliziumsubstraten, insbesondere zur Durchführung des Verfahrens nach einem der vorhergehenden Ansprüche, wobei die Vorrichtung eine horizontale Transportbahn aufweist zum liegenden Transport von Siliziumsubstraten (13) durch die Vorrichtung und zu deren liegender Behandlung, wobei mehrere Benetzungsvorrichtungen (18) angeordnet sind, die über die Breite der Transportbahn reichen, wobei die Benetzungsvorrichtungen nach unten weisende Benetzungsöffnungen (19) und eine Zuführung (22) für Ätzlösung aufweisen, **dadurch gekennzeichnet, dass** zusätzlich ein separater Nachdosierungsanschluss (24) an der Benetzungsvorrichtung, insbesondere nahe der Benetzungsdüsen, vorgesehen ist zum Nachdosieren von Additiv in die Ätzlösung.

9. Vorrichtung nach Anspruch 8, **dadurch gekennzeichnet, dass** eine Heizeinrichtung für die Benetzungsvorrichtung bzw. die Ätzlösung vorgesehen ist, vorzugsweise in der Benetzungsvorrichtung selbst oder in einem Ätzlösungs-Behältnis.

10. Vorrichtung nach Anspruch 8 oder 9, **dadurch gekennzeichnet, dass** mehrere linienartig ausgebildete Benetzungsvorrichtungen vorgesehen sind, die jeweils quer über die Transportbahn für die Siliziumsubstrate verlaufen, wobei die Vorrichtung mehrere derartige Benetzungsvorrichtungen aufweist, die vorzugsweise im Abstand von etwa 10cm bis 20cm entlang der Transportbahn angeordnet sind.

## Claims

1. Method for processing silicon substrates, in particular monocrystalline silicon wafers (13), wherein the silicon substrates are transported while lying flat along a horizontal transport path and etching solution (21) for texturing the surface is applied or sprayed on at least from above by means of nozzles (19) or the like, wherein etching solution is applied from above several times in succession onto the upper side of the silicon substrates, remains there and reacts with the silicon substrate,
**characterized in that**
the etching solution contains an additive from the group consisting of alcohol, surfactant, glycol in a proportion of less than 1 wt%, and wherein more and more additive is added to the etching solution as the etching progresses in time, or in a throughput direction, for an increasing proportion of additive.

2. Method according to Claim 1, **characterized in that** the proportion of additive is between 0.3 wt% and 0.6 wt%.

3. Method according to Claim 1 or 2, **characterized in that** the etching solution is additionally redosed with the additive and/or the etching solution is continuously redosed with the additive.

4. Method according to one of the preceding Claims, **characterized in that** the proportion of additive is increased to the end, preferably up to doubled.

5. Method according to one of the preceding claims, **characterized in that** the etching solution is alkaline, wherein preferably the etching solution comprises an amount of KOH and/or NaOH between 1 wt% and 10 wt%.

6. Method according to one of the preceding Claims, **characterized in that** the etching solution is heated before application onto the silicon substrates, preferably in a stock of etching solution or in a wetting device for the etching solution.

7. Method according to one of the preceding Claims, **characterized in that** the downwardly facing lower side of the silicon substrates is also wetted with the etching solution, preferably by spraying from below or by one or more wetting rollers, over which the silicon substrates travel or are transported and the surface of which is wetted with etching solution in order to transfer the etching solution onto the lower side of the silicon substrates.

8. Device for processing silicon substrates, in particular for carrying out the method according to one of the preceding claims, wherein the device has a horizontal transport path for transporting silicon substrates (13) through the device while they lie flat and for processing them while they lie flat, wherein a plurality of wetting devices (18) are arranged which extend over the width of the transport path, wherein the wetting devices have downwardly facing wetting openings (19) and have a feed (22) for etching solution, **characterized in that**
additionally a separate redoser connection (24) is provided on the wetting device, in particular close to the wetting nozzles, in order to redose additive into the etching solution.

9. Device according to Claim 8, **characterized in that** a heater for the wetting device or the etching solution is provided, preferably in the wetting device itself or in an etching solution container.

10. Device according to Claim 8 or 9, **characterized in that** a plurality of linearly formed wetting devices are provided and each extend transversely over the transport path for the silicon substrates, wherein the device comprises a plurality of such wetting devices, which preferably are arranged with a spacing of about 10 cm to 20 cm along the transport path.

## Revendications

1. Procédé pour le traitement de substrats de silicium, en particulier des wafers de silicium (13) monocristallins, les substrats de silicium étant transportés en position couchée le long d'une voie de transport horizontale et solution de gravure (21) pour texturer la surface étant appliquée ou pulvérisée là-dessus au moins d'en haut à l'aide de buses (19) ou similaire, dans lequel de la solution de gravure est appliquée à plusieurs reprises successivement d'en haut sur la face supérieure des substrats de silicium et reste là-dessus et réagit avec le substrat de silicium,
**caractérisé en ce que**
la solution de gravure contient un additif du groupe composé d'alcool, agent tensioactif, glycol dans une proportion de moins de 1 % en poids, et dans lequel durant le progrès en temps de la gravure ou dans une direction de passage de plus en plus d'additif est ajouté à la solution de gravure pour une proportion d'additif augmentant.

2. Procédé selon la revendication 1, **caractérisé en ce que** la proportion d'additif est comprise entre 0,3 % en poids et 0,6 % en poids.

3. Procédé selon la revendication 1 ou 2, **caractérisé en ce que** l'additif est rajouté en plus dans la solution de gravure et/ou l'additif est rajouté en permanence dans la solution de gravure.

4. Procédé selon l'une quelconque des revendications précédentes, **caractérisé en ce que** la proportion d'additif est augmentée vers la fin, de préférence jusqu'à redoublée.

5. Procédé selon l'une quelconque des revendications précédentes, **caractérisé en ce que** la solution de gravure est alcaline, de préférence présentant une quantité de KOH et/ou de NaOH comprise entre 1 % en poids et 10 % en poids.

6. Procédé selon l'une quelconque des revendications précédentes, **caractérisé en ce que** la solution de gravure est chauffée avant l'application sur les substrats de silicium, de préférence dans une provision de solution de gravure ou dans un dispositif de mouillage pour la solution de gravure.

7. Procédé selon l'une quelconque des revendications précédentes, **caractérisé en ce que** la face inférieure dirigée vers le bas des substrats de silicium aussi est mouillée par la solution de gravure, de préférence au moyen de pulvérisation par le bas ou en utilisant un rouleau ou plusieurs rouleaux de mouillage, les substrats de silicium passant ou étant transportés sur lesdits rouleaux et la surface desdits rouleaux étant mouillée avec solution de gravure pour le transfert de la solution de gravure à la face inférieure des substrats de silicium.

8. Dispositif pour le traitement de substrats de silicium, en particulier pour effectuer le procédé selon l'une quelconque des revendications précédentes, dans lequel le dispositif présente une voie de transport horizontale pour un transport en position couchée de substrats de silicium (13) à travers le dispositif et pour le traitement en position couchée desdits substrats de silicium, dans lequel plusieurs dispositifs de mouillage (19) sont arrangés, s'étendant sur la largeur de la voie de transport, dans lequel les dispositifs de mouillage présentent des ouvertures de mouillage (19) dirigées vers le bas et une amenée (22) pour solution de gravure,
**caractérisé en ce que**
un raccordement pour rajouter (24) séparé est en plus prévu sur le dispositif de mouillage, en particulier proche aux buses de mouillage, pour rajouter de l'additif dans la solution de gravure.

9. Dispositif selon la revendication 8, **caractérisé en ce qu'**un chauffage pour le dispositif de mouillage ou bien la solution de gravure est prévu, de préférence dans le dispositif de mouillage même ou dans un récipient de solution de gravure.

10. Dispositif selon la revendication 8 ou 9, **caractérisé en ce que** plusieurs dispositifs de mouillage sous forme linéaire sont prévus, respectivement s'étendant transversalement sur la voie de transport pour les substrats de silicium, dans lequel le dispositif présente plusieurs de telles dispositifs de mouillage, de préférence espacés d'un intervalle d'environ 10 cm à 20 cm le long de la voie de transport.
